# EUROPÄISCHE PATENTANMELDUNG

(11) **EP 2 533 054 A2**
(43) Veröffentlichungstag der Anmeldung: **12.12.2012**
(21) Anmeldenummer: 12168959.0
(22) Anmeldetag: 22.05.2012
(51) Int. Cl.: G01R 1/067, G01R 19/00

(54) **Zweipoliger Spannungsprüfer mit Prüfelektrodenschutz**

(30) Priorität: 06.06.2011 DE 102011077007
(71) Anmelder: Hoover Dam Technology GmbH, 79286 Glottertal (DE)
(72) Erfinder: Kaiser, Carolin, 9493 Mauren (LI); Andresen, Michael, 78112 St. Georgen (DE); Emberger, Holger-Max, 79211 Denzlingen (DE)
(74) Vertreter: Dilg, Haeusler, Schindelmann Patentanwaltsgesellschaft mbH

(57) **Zusammenfassung**

Es wird ein zweipoliger Spannungsprüfer (100) zum Erfassen des Vorhandenseins und/oder der Höhe einer zwischen zwei Messpunkten anliegenden Spannungsdifferenz beschrieben. Der zweipolige Spannungsprüfer (100) weist auf (a) ein Hauptteil (120) mit einem Hauptgehäuse (122), mit einer im Hauptgehäuse (122) angeordneten Spannungsmesseinrichtung und mit einer am Hauptgehäuse (122) angebrachten ersten Prüfelektrode (124) zum Kontaktieren des Hauptteils (120) mit einem ersten Messpunkt, (b) ein Griffteil (140) mit einem Griffgehäuse (142) und mit einer an dem Griffgehäuse (142) angebrachten zweiten Prüfelektrode (144) zum Kontaktieren des Griffteils (140) mit dem zweiten Messpunkt und (c) eine elektrische Verbindungsleitung (160) mittels welcher die Spannungsmesseinrichtung und die zweite Prüfelektrode (144) elektrisch leitend miteinander verbunden sind. Das Hauptgehäuse (122) und das Griffgehäuse (142) sind derart ausgebildet, dass sie lösbar mechanisch miteinander verbindbar sind. Das Hauptgehäuse (122) weist an seiner Außenseite eine erste Ausnehmung (226) auf und das Griffgehäuse (142) weist an seiner Außenseite eine zweite Ausnehmung (246) auf. Die beiden Ausnehmungen (226, 246) sind derart angeordnet und derart ausgebildet, dass, wenn sich der zweipolige Spannungsprüfer (100) in einem Verbindungszustand befindet, in welchem das Hauptgehäuse (122) und das Griffgehäuse (142) miteinander verbunden sind, zumindest ein Teil der zweiten Prüfelektrode (144) in der ersten Ausnehmung (226) aufgenommen ist und zumindest ein Teil der ersten Prüfelektrode (124) in der zweiten Ausnehmung (246) aufgenommen ist.

## Beschreibung

Die vorliegende Erfindung betrifft allgemein das technische Gebiet von elektrischen Prüfeinrichtungen, mit denen das Vorhandensein und/oder die Höhe von einer zwischen zwei Messpunkten anliegenden Spannungsdifferenz erfasst werden kann. Die vorliegende Erfindung betrifft insbesondere einen zweipoligen Spannungsprüfer, welcher zwei Teile, ein Hauptteil und ein Griffteil, aufweist, die mittels einer elektrischen Verbindungsleitung miteinander verbunden sind und die jeweils eine Prüfelektrode aufweisen.

Zweipolige Spannungsprüfer werden derzeit in Niederspannungsnetzen und bei Elektroinstallationen bis zu 1000 V zum schnellen und sicheren Erfassen des Vorhandenseins und/oder der Höhe einer zwischen zwei Messpunkten anliegenden Spannung eingesetzt. Der genaue Nennspannungsbereich, in dem ein zweipoliger Spannungsprüfer eingesetzt werden darf, hängt von dem jeweiligen Gerät ab und ist typischerweise auf diesem vermerkt. Im Gegensatz zu einpoligen Phasenprüfern liefern zweipoliger Spannungsprüfer sichere Prüfergebnisse. Im Vergleich zu sog. Multimetern sind zweipolige Spannungsprüfer deutlich einfacher zu bedienen. Zusätzlich kann ein Spannungsprüfer üblicherweise unter Verwendung einer elektrischen Last arbeiten. Dadurch wird die Detektion von kapazitiven und/oder induktiv eingekoppelten Strömen verhindert und nur "echte" Spannungen angezeigt. Multimeter habe diese Möglichkeit im Normalfall nicht.

Zweipolige Spannungsprüfer bestehen üblicherweise aus einem Hauptteil mit einer Anzeigeeinheit und einem Griffteil. An jeden der beiden Teile ist eine Prüfelektrode integriert. Zum Schutz des zweipoligen Spannungsprüfers und einer Bedienperson sind insbesondere im Hauptteil mehrere Vorwiderstände vorgesehen, welche einen Prüfstrom begrenzen und die zu erfassende Spannung bis zum eigentlichen Messsystem in dem Hauptteil auf wenige Volt herunter teilen.

Zur Messung werden mit den Prüfelektroden zwei unterschiedliche Messpunkte, die auf unterschiedlichen elektrischen Potentialen liegen (zum Beispiel zwei spannungsführende Leitungen) kontaktiert. Die Anzeige der Spannung kann je nach Typ von zweipoligem Spannungsprüfer mittels eines Zeiger, mittels Lichtpunkten (LEDs oder Glimmlampen) oder mittels einer Digitalanzeige realisiert sein. Eine zweipolige Spannungsmessung mittels eines zweipoligen Spannungsprüfers ist erdungsunabhängig und liefert ein sicheres Prüfergebnis.

Die Prüfelektroden sind in der Regel als Prüfspitzen ausgebildet und können im rauen Alltag eines Handwerkers leicht beschädigt werden. Sie verbiegen sich beispielsweise, wenn der zweipolige Spannungsprüfer ungeschützt in einer Werkzeugtasche transportiert wird und schweres Werkzeug auf dem Spannungsprüfer liegt. Ebenso kann ein unbeabsichtigtes Herunterfallen von zumindest einem Teil des Spannungsprüfers eine Ursache der Beschädigung sein.

In der Praxis wird ein zweipoliger Spannungsprüfer von einer Bedienperson oft um den Hals herum getragen, wenn sie den Spannungsprüfer gerade nicht benötigt. Dabei legt die Bedienperson die Verbindungsleitung um ihren Hals und das Hauptteil sowie das Griffteil hängen nach unten. Die üblicherweise spitzen Prüfelektroden können dann beim Laufen und/oder beim Treppensteigen leicht mit den Beinen der Bedienperson in Kontakt treten. Dies kann zu Verletzungen der Bedienperson und/oder zu einer Beschädigung von deren Kleidungsstücken führen.

Es ist bekannt, einen Spitzenschutz für die beiden Prüfelektroden eines zweipoligen Spannungsprüfers aus einem weichem Kunststoffteil auszuführen, welches über die Spitzen der beiden Prüfelektroden geschoben werden kann. Der Spitzenschutz ist typischerweise verliersicher an der Verbindungsleitung zwischen dem Hauptteil und dem Griffteil befestigt und kann daher nicht genutzt werden, wenn der Spannungsprüfers um den Hals getragen wird. Außerdem ist ein derartiger verliersicher angebrachter Spitzenschutz nur ein sehr begrenzter Schutz gegen Beschädigung in einer Werkzeugkiste oder bei einem Herunterfallen des Spannungsprüfers. Um den Spitzenschutz aufzustecken, muss das Griffteil zunächst an das Hauptteil angelegt und/oder angesteckt werden. Erst danach kann der Spitzenschutz angebracht werden. Diese Handhabung ist jedoch so umständlich, dass der Spitzenschutz in der Praxis von den meisten Bedienpersonen gar nicht benutzt wird.

Um ein Beschädigen von und/oder ein Beschädigen durch die spitzen Prüfelektroden eines zweipoligen Spannungsprüfers zu vermeiden, ist es ferner bekannt, den Spannungsprüfer nach dem Gebrauch in eine geeignete Bereitschaftstasche zu stecken. Die Bereitschaftstasche stellt jedoch ein zusätzliches Teil dar, das angeschafft und transportiert werden muss. Ebenfalls ist die Handhabung einer Bereitschaftstasche umständlich, da der zweipolige Spannungsprüfer zusammengesteckt, die Tasche geöffnet, der Spannungsprüfer in die Bereitschaftstasche eingesteckt und die Bereitschaftstasche wieder verschlossen werden muss. Daher wird auch diese Lösung zum Schutz der Prüfelektroden in der Praxis nur sehr wenig genutzt und die Anzahl an verkauften Bereitschaftstaschen beträgt derzeit nur ca. 5% von der Anzahl der insgesamt verkauften zweipoligen Spannungsprüfer.

Der vorliegenden Erfindung liegt die Aufgabe zugrunde, einen zweipoligen Spannungsprüfer zu schaffen, welcher auf einfache Weise einen effektiven und einfach zu handhabbaren Schutz der Prüfelektroden gewährleistet.

Diese Aufgabe wird gelöst durch die Gegenstände des unabhängigen Patentanspruchs. Vorteilhafte Ausführungsformen der vorliegenden Erfindung sind in den abhängigen Ansprüchen beschrieben.

Gemäß einem ersten Aspekt der Erfindung wird ein zweipoliger Spannungsprüfer zum Erfassen des Vorhandenseins und/oder der Höhe einer zwischen zwei Messpunkten anliegenden Spannungsdifferenz beschrieben. Der zweipolige Spannungsprüfer weist auf (a) ein Hauptteil mit einem Hauptgehäuse, mit einer im Hauptgehäuse angeordneten Spannungsmesseinrichtung und mit einer am Hauptgehäuse angebrachten ersten Prüfelektrode zum Kontaktieren des Hauptteils mit einem ersten Messpunkt, (b) ein Griffteil mit einem Griffgehäuse und mit einer an dem Griffgehäuse angebrachten zweiten Prüfelektrode zum Kontaktieren des Griffteils mit dem zweiten Messpunkt und (c) eine elektrische Verbindungsleitung mittels welcher die Spannungsmesseinrichtung und die zweite Prüfelektrode elektrisch leitend miteinander verbunden sind. Erfindungsgemäß sind das Hauptgehäuse und das Griffgehäuse derart ausgebildet, dass sie lösbar mechanisch miteinander verbindbar sind. Ferner weist das Hauptgehäuse an seiner Außenseite eine erste Ausnehmung auf und das Griffgehäuse weist an seiner Außenseite eine zweite Ausnehmung auf. Außerdem sind die beiden Ausnehmungen derart angeordnet und derart ausgebildet, dass, wenn sich der zweipolige Spannungsprüfer in einem Verbindungszustand befindet, in welchem das Hauptgehäuse und das Griffgehäuse miteinander verbunden sind, zumindest ein Teil der zweiten Prüfelektrode in der ersten Ausnehmung aufgenommen ist und zumindest ein Teil der ersten Prüfelektrode in der zweiten Ausnehmung aufgenommen ist.

Dem beschriebenen zweiteiligen Spannungsprüfer liegt die Erkenntnis zugrunde, dass ein einfach handhabarer und trotzdem effektiver Schutz der Prüfelektroden dadurch erreicht werden kann, dass in den beiden Gehäuseteilen jeweils an deren Außenseite eine Ausnehmung ausgebildet ist, in welchen sich die Spitze der Prüfelektrode des jeweils anderen Gehäuseteils aufnehmen lässt. Die beiden Ausnehmungen sind dabei derart angeordnet, dass in dem genannten Verbindungszustand, bei dem die beiden Gehäuseteile, d.h. das Hauptgehäuse und das Griffgehäuse, direkt miteinander und nicht lediglich indirekt über die Verbindungsleitung mechanisch miteinander gekoppelt sind, zumindest ein Teil der Prüfelektrode des jeweils anderen Gehäuseteils aufgenommen ist. Bevorzugt ist zumindest eine Ausnehmung so lange, dass die Prüfelektrode des anderen Gehäuseteils entlang ihrer gesamten Länge aufgenommen werden kann.

Der beschriebene zweiteilige Spannungsprüfer stellt somit eine technisch einfache Lösung für die im Zusammenhang mit der schlechten Handhabbarkeit von herkömmlichen zweipoligen Spannungsprüfern bekannten Schwachstellen bereit. Der Schutz insbesondere der Spitzen der Prüfelektroden durch ein einfaches ineinander Stecken beseitigt alle Handhabungsschwachstellen heutiger Spannungsprüfer und kann auf einfache Weise und kosteneffektiv in eine Massenproduktion von zweipoligen Spannungsprüfern umgesetzt werden.

Gemäß einem Ausführungsbeispiel der Erfindung weist das Hauptgehäuse an einer seiner Außenseiten ein erstes Konturelement mit einer ersten dreidimensionalen Kontur auf und das Griffgehäuse weist an einer seiner Außenseiten ein zweites Konturelement mit einer zweiten dreidimensionalen Kontur auf. Die zweite dreidimensionale Kontur ist zumindest teilweise komplementär zu der ersten dreidimensionalen Kontur. Dies hat den Vorteil, dass durch eine geeignete Formgebung der beiden Konturelemente auf einfache Weise eine zuverlässige mechanisch lösbare Verbindung zwischen den beiden Gehäuseteilen realisierbar ist. Beispielsweise kann eines der beiden Konturelemente ausgehend von der Oberfläche des betreffenden Gehäuseteils nach einem verjüngten oder dünnen Abschnitt einen eine Verbreiterung aufweisenden Abschnitt aufweisen und das andere der beiden Konturelemente kann eine Öffnung mit einer Hinterschneidung aufweisen, in welche das eine der beiden Konturelemente eingreift oder hineingesteckt werden kann. Eine mechanische Kopplung der beiden Gehäuseteile kann damit auf einfache Weise durch ein Aneinanderstecken des Griffgehäuses an das Hauptgehäuse und/oder durch ein Aneinanderstecken des Hauptgehäuses an das Griffgehäuse erfolgen.

Die beiden Konturelemente und/oder die beiden Gehäuseteile können derart ausgestaltet sein, dass der zweipolige Spannungsprüfer im Verbindungszustand zumindest in Bezug auf die beiden Teile, d.h. den Hauptteil und den Griffteil, eine kompakte Einheit darstellt. Diese kompakte Einheit kann sich eine Bedienperson dann unter Verwendung der elektrischen Verbindungsleitung beispielsweise um den Hals hängen. Aufgrund der wechselseitigen Aufnahme der beiden Prüfelektroden in den jeweils anderen Gehäuseteil (Hauptgehäuse bzw. Griffgehäuse) besteht dann keine Gefahr mehr von Verletzungen und/oder von Beschädigungen an der Kleidung einer Bedienperson.

Gemäß einem weiteren Ausführungsbeispiel der Erfindung bilden die beiden Konturelemente zusammen einen Einschnapp-Mechanismus. Dies hat den Vorteil, dass der Verbindungszustand, in welchem das Hauptgehäuse und das Griffgehäuse lösbar miteinander verbunden sind, durch eine einfache Handbewegung hergestellt werden kann. Beispielsweise kann das Griffteil mittels einer einfachen Handbewegung an den Hauptteil geklickt werden.

Dieses Klicken oder Einschnappen kann vorzugsweise positionsgenau erfolgen. Somit ist im Vergleich zu der Handhabung eines keinen Prüfelektrodenschutz aufweisenden Spannungsprüfers kaum ein zusätzlicher Handhabungsaufwand erforderlich, um die beiden Prüfelektroden wirksam vor Beschädigungen zu schützen. Dies wird auf Seiten der Benutzer des beschriebenen zweiteiligen Spannungsprüfers zu einer großen Akzeptanz führen, die beiden Prüfelektroden und damit den gesamten zweiteiligen Spannungsprüfer vor möglichen Beschädigungen zu schützen.

Es wird darauf hingewiesen, dass ein Einschnappen durch eine Relativbewegung der beiden Gehäuseteile aufeinander zu und/oder durch eine seitliche Verschiebebewegung der beiden Gehäuseteile relativ zueinander erfolgen kann.

Gemäß einem weiteren Ausführungsbeispiel der Erfindung bildet das erste Konturelement zusammen mit dem zweiten Konturelement eine Nut-Feder Kombination.

Die beschriebene Nut-Feder Kombination ist bevorzugt in der Mitte des (zusammengesetzten) Spannungsprüfers an den beiden Gehäuseteilen ausgebildet, welche bevorzugt einen Kunststoff aufweisen oder ganz aus Kunststoff bestehen. An der Nut-Feder-Kombination kann beispielsweise die (zweite) Prüfelektrode des Griffteils in das Hauptgehäuse des Hauptteils einschnappen. Ebenso kann an der Nut-Feder-Kombination die (erste) Prüfelektrode des Hauptteils in das Griffgehäuse des Griffteils einschnappen. Dann bilden die beiden Prüfelektroden, welche jeweils in einer Ausnehmung aufgenommen sind, eine kompakte Einheit, wobei die Spitzen der Prüfelektroden nicht mehr von den Gehäuseteilen des zweipoligen Spannungsprüfers freistehenden. Zusammen mit der Verbindungsleitung wird somit eine geschlossene Schlinge gebildet, welche von einer Bedienperson einfach um den Hals gelegt werden kann, wenn der beschriebene zweipolige Spannungsprüfer gerade nicht gebraucht wird.

Gemäß einem weiteren Ausführungsbeispiel der Erfindung weist zumindest eines der beiden Konturelemente eine längliche Form auf und das andere Konturelement ist derart ausgebildet, dass es nach einem Eingriff mit dem einen länglichen Konturelement relativ zu diesem verschiebbar ist. Dies hat den Vorteil, dass die beiden Gehäuseteile durch eine seitliche Verschiebebewegung relativ zueinander miteinander verbunden werden können. Dabei wird insbesondere das andere Konturelement in das eine längliche Konturelement eingeführt oder um das eine längliche Konturelement herum so angeordnet, dass es beispielsweise wie bei einer einfachen Linearführung entlang des einen länglichen Konturelements verschoben werden kann. Die finale (Relativ)Position der beiden Gehäuseteile zueinander kann dabei durch einen weiteren Schnapp-Mechanismus festgelegt sein, der ein Ende der beschriebenen Verschiebebewegung definiert.

Anschaulich gesprochen kann dies bedeuten, dass zum Herstellen des genannten Verbindungszustandes die beiden Gehäuseteile zumindest mit den oben beschriebenen Konturelementen ineinander geschoben werden. Auf diese Weise kann eine besonders zuverlässige lösbare Verbindung zwischen dem Hauptteil und dem Griffteil hergestellt werden.

Gemäß einem weiteren Ausführungsbeispiel der Erfindung sind das Hauptteil und das Griffteil derart ausgebildet, dass in dem Verbindungszustand des zweipoligen Spannungsprüfers die beiden Prüfelektroden mit zueinander in umgekehrter Orientierung ausgerichtet sind. Dies kann insbesondere bedeuten, dass die erste Prüfelektrode mit ihrer (ersten) Prüfspitze in eine erste Richtung zeigt, wohingegen die zweite Prüfelektrode mit ihrer (zweiten) Prüfspitze in eine zweite Richtung zeigt, welche entgegengesetzt (d.h. antiparallel oder um 180° verdreht) zu der ersten Richtung zeigt. Beim Zusammensetzen der beiden Gehäuseteile in den Verbindungszustand kann somit die zweite Prüfelektrode im Vergleich zu der ersten Prüfelektrode umgekehrt auf, an und/oder in das Hauptteil geklickt werden. Entsprechend kann die erste Prüfelektrode im Vergleich zu der zweiten Prüfelektrode umgekehrt auf, an und/oder in das Griffteil geklickt werden.

Gemäß einem weiteren Ausführungsbeispiel der Erfindung ist die erste Ausnehmung eine erste Nut und/oder die zweite Ausnehmung ist eine zweite Nut. Dies hat den Vorteil, dass eine als Nut ausgebildete Ausnehmung einfach an dem Hautgehäuse und/oder an dem Griffgehäuse angebracht werden kann. Die Herstellung der beiden Gehäuseteile des beschriebenen Spannungsprüfers erfordert im Vergleich zu herkömmlichen Spannungsprüfern keinen zusätzlichen oder lediglich einen geringfügigen zusätzlichen Aufwand, welcher von dem oben beschriebenen großen Nutzen hinsichtlich der praktischen Handhabung des zweiteiligen Spannungsprüfers gerechtfertigt wird.

Nach dem Zusammenstecken bzw. nach dem mechanisch lösbaren Verbinden der beiden Gehäuseteile befindet sich also zumindest eine Prüfelektrode in einer Nut und ist damit optimal vor mechanischen Beschädigungen geschützt. Auch bei einem Herunterfallen des in seinem Verbindungszustand befindlichen Spannungsprüfers ist es praktisch unmöglich, dass die ansonsten freistehende(n) und sensible(n) Prüfspitze(n) der Prüfelektrode(n) beschädigt wird(werden). Der beschriebene Spannungsprüfer kann also den Boden auf keinen Fall mit der Prüfelektrode berühren, die gerade in der Nut versenkt ist. Auch in einer Werkzeugkiste bilden die beiden Gehäuseteile zusammen mit den in den Nuten wechselseitig aufgenommenen Prüfelektroden eine kompakte Einheit, so dass auch hier das Beschädigungsrisiko minimiert ist.

Gemäß einem weiteren Ausführungsbeispiel der Erfindung ist die erste Nut und/oder die zweite Nut als V-förmige Nut ausgebildet. Dies hat den Vorteil, dass die jeweilige Prüfelektrode, welche im Verbindungszustand des zweipoligen Spannungsprüfers in der V-förmigen Nut aufgenommen ist, besonders sicher entlang zumindest eines längeren Abschnitts der Längsausstreckung der Prüfelektrode in einer festen räumlichen Position gehalten werden kann. Abhängig von der Dicke oder dem Durchmesser der jeweiligen Prüfelektrode kann die V-förmige Nut an ihrer tiefsten Stelle beispielsweise eine Tiefe von 3 mm haben.

Gemäß einem weiteren Ausführungsbeispiel der Erfindung weisen zumindest einige Kanten des Hauptgehäuses und/oder des Griffgehäuses ein elastisches Material auf. Dies hat den Vorteil, dass beim Herunterfallen des beschriebenen zweiteiligen Spannungsprüfers und insbesondere beim Herunterfallen des Hauptteils und/oder des Griffteils unerwünschte Beschädigungen an dem Spannungsprüfer vermieden werden können. Das elastische Material kann an den Kanten beispielsweise durch ein Umspritzen derselben mit einer Kunststoff-Weichteilkomponente angebracht werden, so dass das entsprechende Gehäuseteil robust gegenüber mechanischen Erschütterungen ist.

Der Begriff elastisches Material kann in diesem Zusammenhang insbesondere dahingehend verstanden werden, dass die Elastizität des entsprechenden Kantenmaterials größer ist als die Elastizität der Materials, aus dem insbesondere die flächigen Teile der beiden Gehäuseflächen gefertigt sind.

Gemäß einem weiteren Ausführungsbeispiel der Erfindung ist die Außenseite des Hauptgehäuses in Bezug zu einer Längsachse des Hauptteils eine seitliche Außenseite. Alternativ oder in Kombination ist die Außenseite des Griffgehäuses in Bezug zu einer Längsachse des Griffteils eine seitliche Außenseite.

Dies kann insbesondere bedeuten, dass die betreffende mit einer Ausnehmung versehene Außenseite oder eine zumindest einen Teil dieser Außenseite definierende Oberfläche parallel zu der Längsachse orientiert ist. Damit verändert die betreffende Ausnehmung den Querschnitt des jeweiligen Teils bezüglich seiner Längsachse.

Anschaulich ausgedrückt kann dies bedeuten, dass in Bezug zu der Längsachse bzw. zu einer zu der Längsachse parallelen Längsrichtung des jeweiligen Teils (Hauptteil und/oder Griffteil) die Ausnehmung eben gerade nicht an einer vorderen oder an einer hinteren Stirnfläche ausgebildet sind. Ein die Orientierung der betreffenden Außenseite bestimmender Normalenvektor steht somit winklig und insbesondere zumindest annähernd senkrecht zu der jeweiligen Längsachse.

Unter dem Begriff Längsachse oder Längsrichtung ist in diesem Zusammenhang insbesondere eine Achse bzw. eine Richtung zu verstehen, entlang welcher das betreffende Teil (Hauptteil bzw. Griffteil) seine längste körperliche Ausdehnung hat. Insbesondere bestimmt die Längsachse die Orientierung von zumindest einem Abschnitt des Haupt- bzw. Griffteils, welcher Abschnitt beim Betrieb des zweipoligen Spannungsprüfers von der Hand einer Bedienperson zumindest teilweise umgriffen werden kann.

Die hier beschriebene Ausbildung der Ausnehmungen an den beiden seitlichen Außenseiten hat den Vorteil, dass ein Zusammenstecken der der beiden Teile, welches zu dem oben beschriebenen Schutz der Prüfelektroden führt, besonders einfach von einer Bedienperson erreicht werden kann. Ein wechselseitiges Einführen der Prüfelektroden in Löcher, die an einer Stirnseite des jeweiligen Teils ausgeformt sind, ist auf vorteilhafte Weise nicht erforderlich.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
- Figur 1: zeigt einen zweipoligen Spannungsprüfer in einem Zustand, in dem Hauptteil und Griffteil räumlich voneinander getrennt und nur durch eine elektrische Verbindungsleitung miteinander verbunden sind.
- Figur 2: illustriert wie der in Figur 1 dargestellte zweipolige Spannungsprüfer so zusammengesteckt wird, dass sich (i) eine erste Prüfspitze des Hauptteils in einer zweiten Ausnehmung des Griffteils und (ii) eine zweite Prüfspitze des Griffteils in einer ersten Ausnehmung des Hauptteils befindet.
- Figur 3: zeigt eine perspektivische Darstellung des zusammengesteckten zweipoligen Spannungsprüfers.
- Figur 4: zeigt wie der zusammengesteckte zweipolige Spannungsprüfer von einer Bedienperson um den Hals getragen werden kann.

Es wird darauf hingewiesen, dass gleiche Merkmale bzw. Komponenten, die in unterschiedlichen Figuren dargestellt sind, mit dem gleichen Bezugszeichen versehen sind. Zur Vermeidung von unnötigen Wiederholungen werden bereits anhand einer vorherig beschriebenen Figur erläuterte Merkmale bzw. Komponenten an späterer Stelle nicht mehr im Detail erläutert.

Ferner wird darauf hingewiesen, dass die nachfolgend beschriebene Ausführungsform lediglich eine beschränkte Auswahl an möglichen Ausführungsvarianten der Erfindung darstellt.

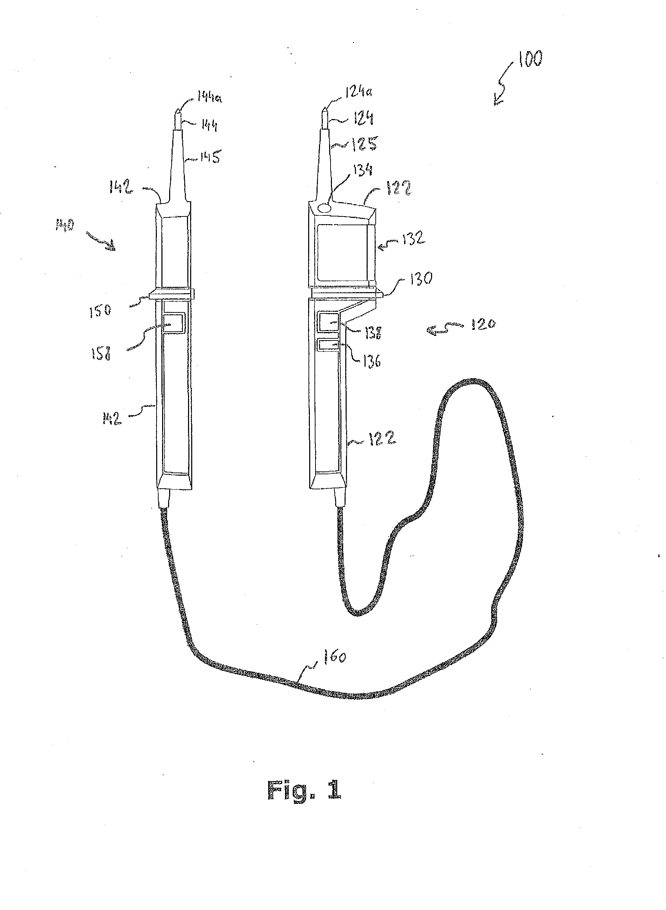

Figur 1 zeigt einen zweipoligen Spannungsprüfer 100, welcher ein Hauptteil 120 und ein Griffteil 140 aufweist, welche in bekannter Weise mittels einer elektrischen Verbindungsleitung 160 miteinander verbunden sind. Mit dem zweipoligen Spannungsprüfer 100 kann das Vorhandensein und/oder die Höhe von einer zwischen zwei Messpunkten anliegenden Spannungsdifferenz erfasst werden. Ferner kann mit dem hier nachfolgend beschriebenen Spannungsprüfer 100 ein elektrischer Durchgang und die Lage eine Drehfeldes detektiert werden. Diese Nebenfunktionen, welche nicht alle am Markt erhältlichen zweipoligen Spannungsprüfer zur Verfügung stellen, werden nachfolgend jedoch nicht weiter beschrieben.

Das Hauptteil 120 weist ein Hauptgehäuse 122 auf, welches bevorzugt aus einem Kunststoffmaterial gefertigt ist. Um das Hauptteil 120 vor mechanischen Beschädigungen zu schützen, sind gemäß dem hier dargestellten Ausführungsbeispiel die Kanten des Hauptgehäuses 122 mit einem weichelastischen Kunststoffmaterial geschützt. An dem vorderen Ende des Hauptgehäuses 122 (in Figur 1 oben) befindet sich eine erste Prüfelektrode 124, welche zum Teil mit einer elektrischen Isolierung 125 umgeben ist. An dem vorderen Ende der Prüfelektrode 124 befindet sich frei von einer Isolierung eine Prüfspitze 124a, welche bei einem Messvorgang mit einem elektrischen Messpunkt in Kontakt gebracht wird.

Um eine sichere Handhabung zu gewährleisten und um insbesondere ein Abrutschen der Hand einer Bedienperson zu vermeiden, ist an dem Hauptgehäuse 122 ein senkrecht zur Längserstreckung des Hauptteils 120 orientierter Steg 130 ausgeformt, welcher bevorzugt ebenfalls aus einem weichelastischen Kunststoffmaterial hergestellt ist. Gemäß dem hier dargestellten Ausführungsbeispiel verläuft der Steg 130 um das gesamte Hauptgehäuse 122 herum und kann deshalb auch als Abrutsch(vermeidungs)ring 130 bezeichnet werden.

In dem Hauptgehäuse 122 integriert befindet sich eine nicht dargestellte Spannungsmesseinrichtung, welche mit einer Spannungsanzeige 132 gekoppelt ist. Die Spannungsanzeige 132 kann eine analoge und/oder digitale Anzeige aufweisen. Gemäß dem hier dargestellten Ausführungsbeispiel weist die Spannungsanzeige 132 an ihren seitlichen Randbereich, welcher dem Rand des Hauptgehäuses 122 entspricht), eine Zeile aus verschiedenen Leuchtdioden auf, wobei in bekannter Weise jede einzelne Leuchtdiode ab dem Erreichen eines bestimmten charakteristischen Spannungswertes aufleuchtet. Wie aus Figur 1 ersichtlich, erstrecken sind die Leuchtdioden um die Kante des Hauptgehäuses 122 herum, so dass die Leuchtdioden der Zeile nicht nur von vorne sondern auch von der Seite und sogar von der Rückseite des Hauptteils 120 von einer Bedienperson gesehen werden können.

Der Hauptteil 120 weist ferner eine Lampe 134 auf, welche durch Drücken eines Tastschalters 136 angeschaltet werden kann. Dies erleichtert die Handhabung des Spannungsprüfers 100 insbesondere in dunklen Arbeitsräumen. Selbstverständlich kann die Lampe und/oder zumindest eine weitere Lampe auch an anderer Stelle an dem Hauptteil 120 angebracht sein.

Ferner weist der Hauptteil 120 noch einen Tastschalter 138 auf, welcher gemäß dem hier dargestellten Ausführungsbeispiel zwischen dem Taster 136 und der Spannungsanzeige 132 angeordnet ist. Der Tastschalter 138 dient dazu, um kurzfristig einen relativ großen Stromfluss durch den zweipoligen Spannungsprüfer 100 zu erlauben und dabei beispielsweise das korrekte Auslösen eines Fehlerstromschutzschalters zu testen. Das Zuschalten der Last erfolgt immer über das Drücken des Tastschalters 138 und eines weiteres Tastschalters 158, welcher sich an dem Griffteil 140 befindet. Ein korrektes Auslösen eines Fehlerstromschutzschalters kann damit aus Sicherheitsgründen nur mittels einer Zweihandbedienung getestet werden.

Es wird ausdrücklich darauf hingewiesen, dass die dargestellte Anordnung von Spannungsanzeige 132, Lampe 134 und den beiden Tastern 136 und 138 nur beispielhaft ist und dass selbstverständlich auch andere räumliche Anordnungen möglich sind.

Das Griffteil 140 weist ein Griffgehäuse 142 auf, welches bevorzugt ebenfalls aus einem Kunststoffmaterial gefertigt ist. Um das Griffteil 140 vor mechanischen Beschädigungen zu schützen, sind gemäß dem hier dargestellten Ausführungsbeispiel auch die Kanten des Griffgehäuses 142 mit einem weichelastischen Kunststoffmaterial geschützt. An dem vorderen Ende des Griffgehäuses 142 (in Figur 1 oben) befindet sich eine zweite Prüfelektrode 144, welche zum Teil mit einer elektrischen Isolierung 145 umgeben ist. An dem vorderen Ende der Prüfelektrode 144 befindet sich frei von einer Isolierung eine Prüfspitze 144a, welche bei einem Messvorgang mit einem weiteren elektrischen Messpunkt in Kontakt gebracht wird.

Um auch eine sichere Handhabung des Griffteils 140 zu gewährleisten und um insbesondere ein Abrutschen der Hand einer Bedienperson zu vermeiden, ist an dem Griffgehäuse 142 ein senkrecht zur Längserstreckung des Griffteils 140 orientierter Steg 150 ausgeformt, welcher bevorzugt ebenfalls aus einem weichelastischen Kunststoffmaterial hergestellt ist. Gemäß dem hier dargestellten Ausführungsbeispiel verläuft der Steg 150 um das gesamte Griffgehäuse 142 herum und kann deshalb ebenfalls auch als Abrutsch(vermeidungs)ring 150 bezeichnet werden.

Ferner weist der Griffteil 140 noch einen Tastschalter 158 auf. Der Tastschalter 138 dient dazu, um bei einer Betätigung zusammen mit dem Tastschalter 138 des Hauptteils 120 kurzfristig einen relativ großen Stromfluss durch den zweipoligen Spannungsprüfer 100 zu erlauben und dabei beispielsweise das korrekte Auslösen eines Fehlerstromschutzschalters zu testen.

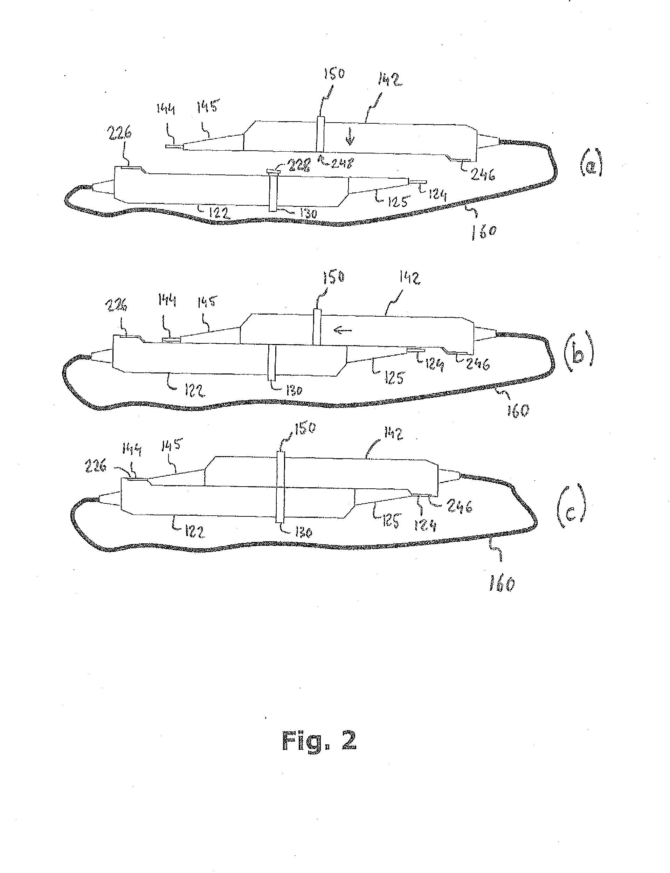

Figur 2 illustriert wie der zweipolige Spannungsprüfer 100 so zusammengesteckt wird, dass sich auf effektive Weise ein wirksamer Schutz der beiden Prüfspitzen 124a und 144a ergibt. Wie aus Figur 2(a) ersichtlich, weist das Hauptgehäuse 122 an seinem hinteren Ende, wo die elektrische Verbindungsleitung 160 in das Hauptteil 120 mündet, eine als Nut ausgebildete erste Ausnehmung 226 auf. Entsprechend weist das Griffgehäuse 142 an seinem hinteren Ende, wo die elektrische Verbindungsleitung 160 in das Griffteil 120 mündet, eine als Nut ausgebildete zweite Ausnehmung 246 auf. Gemäß dem hier dargestellten Ausführungsbeispiel sind haben die beiden Nuten 226 und 246 eine V-förmige Querschnittsform.

Das Hauptgehäuse 122 weist ferner ein erstes dreidimensional geformtes Konturelement 228 auf, welches mit einem komplementären zweiten Konturelement 248 zumindest teilweise in Eingriff gebracht werden kann. Gemäß dem hier dargestellten Ausführungsbeispiel ist das zweite Konturelement 248 in Figur 2(a) mittels einer länglichen Aussparung realisiert. Die längliche Aussparung weist an einer Stelle eine Öffnung auf, in welche das Konturelement 228 eingeführt werden kann. Entlang der länglichen Aussparung ist, abgesehen von dem Bereich der Öffnung, eine nicht dargestellte längliche Hinterschneidung ausgebildet, welche durch eine Parallelverschiebung der beiden aneinander angelegten Gehäuseteile 122 und 142 mit dem ersten Konturelement 228 in Eingriff gebracht werden kann. Das Ende dieser in Figur 2 horizontal verlaufenden Relativbewegung befindet sich ein Anschlag mit einer Einrast-Funktionalität, so dass die relative Endposition zwischen beiden Gehäuseteilen 122 und 142, die in Figur 2(c) dargestellt ist, genau festgelegt ist. In dieser Endposition fluchten die beiden Stege 130 und 150 miteinander.

Um die beiden in Figur 2(a) getrennt angeordneten Gehäuseteile 122 und 142 in ihre relative Endposition zu bringen, wird das Griffgehäuse 142 entlang des in Figur 2(a) dargestellten vertikalen Pfeils nach unten (und/oder das Hauptgehäuse 122 entgegen des Richtung dieses Pfeiles nach oben) verschoben, bis das erste Konturelement 228 in die oben beschriebene Öffnung eingreift. Dieser Zustand, in dem die beiden Gehäuseteile 122 und 142 aneinander anliegen, ist in Figur 2(b) gezeigt.

Um die beiden Gehäuseteile 122 und 142 relativ zueinander in die oben genannte relative Endposition zu bringen, wird das Griffgehäuse 142 dann relativ zu dem Hauptgehäuse 122 horizontal entlang des in Figur 2(b) dargestellten horizontalen Verschiebepfeils nach links (und/oder das Hauptgehäuse 142 wird nach rechts) verschoben. Dabei bewegt sich dann die Prüfspitze der ersten Prüfelektrode 124 in die Nut 246 und die Prüfspitze der zweiten Prüfelektrode 144 bewegt sich in die Nut 226. Auf diese Weise sind beide Prüfspitzen sicher in der jeweiligen Nut 246 bzw. 226 aufgenommen und es kann eine sowohl eine mechanische Beschädigung an den Prüfspitzen als auch eine Beschädigung wie z.B. eine Verletzung einer Bedienperson durch die Prüfspitzen verhindert werden. Dieser Zustand ist in Figur 2(c) dargestellt.

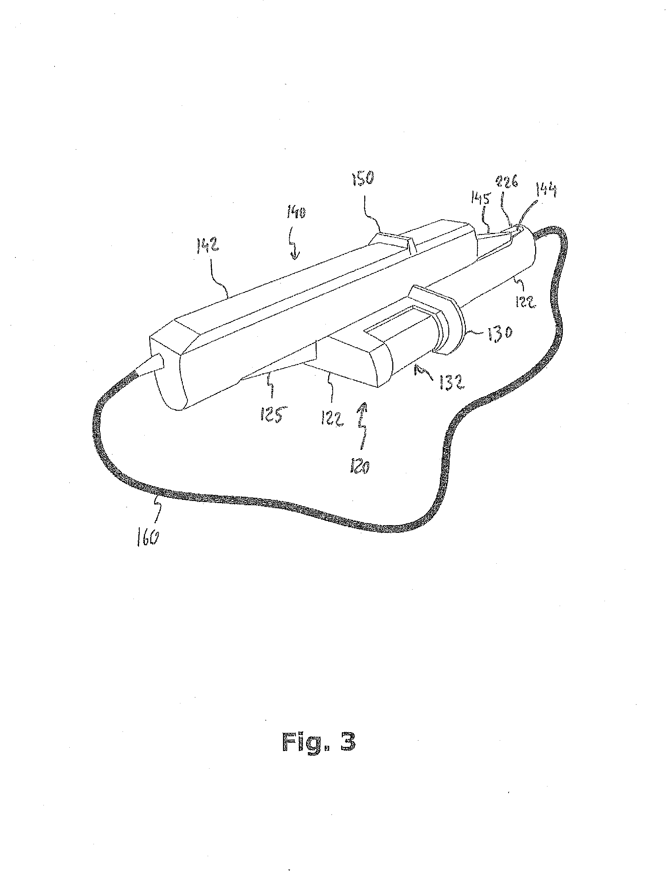

Figur 3 zeigt eine perspektivische Darstellung des zusammengesteckten zweipoligen Spannungsprüfers. Es ist deutlich zu erkennen, wie die Prüfspitze der zweiten Prüfelektrode 144 des Griffteils 140 in der ersten nutförmigen Ausnehmung 226 des Hauptteils 120 aufgenommen ist. Die Aufnahme der Prüfspitze der ersten Prüfelektrode des Hauptteils 140 in der zweiten nutförmigen Aussparung des Griffteils 140 ist in der perspektivischen Darstellung nicht zu erkennen.

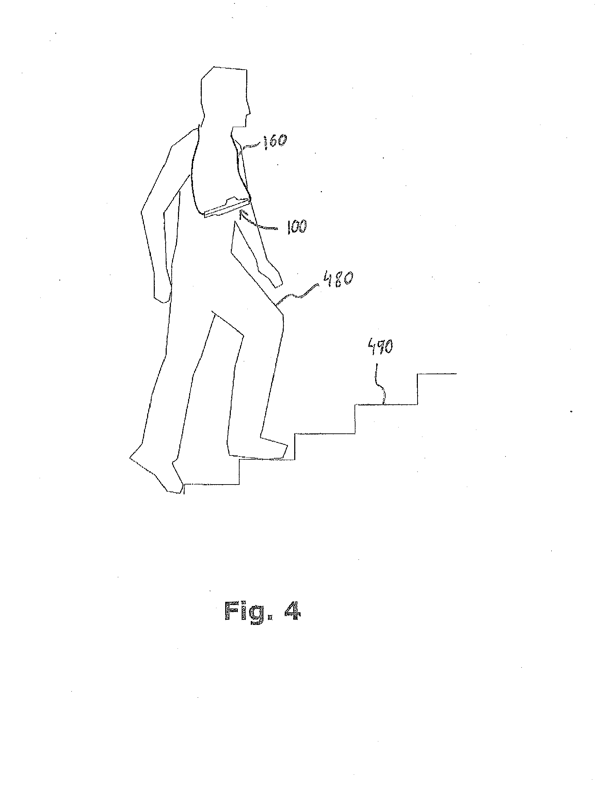

Figur 4 zeigt wie der zusammengesteckte zweipolige Spannungsprüfer 100 von einer Bedienperson 480 um deren Hals getragen wird. Da die beiden Prüfspitzen nicht frei hängen sondern jeweils in dem Gehäuseteil des anderen Teils des Spannungsprüfers 100 aufgenommen und damit geschützt sind, kann sich die Bedienperson auch dann nicht den Oberschenkel verletzen, wenn sie eine Treppe 490 beispielsweis nach oben steigt.

### BEZUGSZEICHEN:

- 100: Zweipoliger Spannungsprüfer
- 120: Hauptteil
- 122: Hauptgehäuse
- 124: erste Prüfelektrode
- 124a: Prüfspitze
- 125: Isolierung
- 130: Steg (Abrutschring)
- 132: Spannungsanzeige
- 134: Lampe
- 136: Tastschalter für Lampe
- 138: Tastschalter für Auslösung Fehlerstromschutzschalter
- 140: Griffteil
- 142: Griffgehäuse
- 144: zweite Prüfelektrode
- 144a: Prüfspitze
- 145: Isolierung
- 150: Steg (Abrutschring)
- 158: Tastschalter für Auslösung Fehlerstromschutzschalter
- 160: elektrische Verbindungsleitung

- 226: erste Ausnehmung / erste Nut
- 228: erstes Konturelement
- 246: zweite Ausnehmung / zweite Nut
- 248: zweites Konturelement

- 480: Bedienperson
- 490: Treppe

## Patentansprüche

1. Zweipoliger Spannungsprüfer zum Erfassen des Vorhandenseins und/oder der Höhe einer zwischen zwei Messpunkten anliegenden Spannungsdifferenz, der zweipolige Spannungsprüfer (100) aufweisend
ein Hauptteil (120) mit einem Hauptgehäuse (122), mit einer im Hauptgehäuse (122) angeordneten Spannungsmesseinrichtung und mit einer am Hauptgehäuse (122) angebrachten ersten Prüfelektrode (124) zum Kontaktieren des Hauptteils (120) mit einem ersten Messpunkt,
ein Griffteil (140) mit einem Griffgehäuse (142) und mit einer an dem Griffgehäuse (142) angebrachten zweiten Prüfelektrode (144) zum Kontaktieren des Griffteils (140) mit dem zweiten Messpunkt, und
eine elektrische Verbindungsleitung (160) mittels welcher die Spannungsmesseinrichtung und die zweite Prüfelektrode (144) elektrisch leitend miteinander verbunden sind,
wobei das Hauptgehäuse (122) und das Griffgehäuse (142) derart ausgebildet sind, dass sie lösbar mechanisch miteinander verbindbar sind,
wobei das Hauptgehäuse (122) an seiner Außenseite eine erste Ausnehmung (226) aufweist,
wobei das Griffgehäuse (142) an seiner Außenseite eine zweite Ausnehmung (246) aufweist und
wobei die beiden Ausnehmungen (226, 246) derart angeordnet und derart ausgebildet sind, dass, wenn sich der zweipolige Spannungsprüfer (100) in einem Verbindungszustand befindet, in welchem das Hauptgehäuse (122) und das Griffgehäuse (142) miteinander verbunden sind, zumindest ein Teil der zweiten Prüfelektrode (144) in der ersten Ausnehmung (226) aufgenommen ist und zumindest ein Teil der ersten Prüfelektrode (124) in der zweiten Ausnehmung (246) aufgenommen ist.

2. Zweipoliger Spannungsprüfer gemäß dem vorangehenden Anspruch, wobei das Hauptgehäuse (122) an einer seiner Außenseiten ein erstes Konturelement (228) mit einer ersten dreidimensionalen Kontur aufweist,
das Griffgehäuse (142) an einer seiner Außenseiten ein zweites Konturelement (248) mit einer zweiten dreidimensionalen Kontur aufweist, welche zumindest teilweise komplementär zu der ersten dreidimensionalen Kontur ist.

3. Zweipoliger Spannungsprüfer gemäß dem vorangehenden Anspruch, wobei die beiden Konturelemente (228, 248) zusammen einen Einschnapp-Mechanismus bilden.

4. Zweipoliger Spannungsprüfer gemäß einem der vorangehenden Ansprüche 2 bis 3, wobei
das erste Konturelement (228) zusammen mit dem zweiten Konturelement (248) eine Nut-Feder Kombination bildet.

5. Zweipoliger Spannungsprüfer gemäß einem der vorangehenden Ansprüche 2 bis 4, wobei
zumindest eines der beiden Konturelemente (248) ein längliche Form aufweist und das andere Konturelement (228) derart ausgebildet ist, dass es nach einem Eingriff mit dem einen länglichen Konturelement (248) relativ zu diesem verschiebbar ist.

6. Zweipoliger Spannungsprüfer gemäß einem der vorangehenden Ansprüche 1 bis 5, wobei
das Hauptteil (120) und das Griffteil (140) derart ausgebildet sind, dass in dem Verbindungszustand des zweipoligen Spannungsprüfers (100) die beiden Prüfelektroden (124, 144) mit zueinander in umgekehrter Orientierung ausgerichtet sind.

7. Zweipoliger Spannungsprüfer gemäß einem der vorangehenden Ansprüche 1 bis 6, wobei
die erste Ausnehmung eine erste Nut (226) ist und/oder die zweite Ausnehmung eine zweite Nut (246) ist.

8. Zweipoliger Spannungsprüfer gemäß dem vorangehenden Anspruch, wobei die erste Nut (226) und/oder die zweite Nut (246) als V-förmige Nut ausgebildet ist.

9. Zweipoliger Spannungsprüfer gemäß einem der vorangehenden Ansprüche 1 bis 8, wobei
zumindest einige Kanten des Hauptgehäuses (122) und/oder des Griffgehäuses (142) ein elastisches Material aufweisen.

10. Zweipoliger Spannungsprüfer gemäß einem der vorangehenden Ansprüche 1 bis 9, wobei
die Außenseite des Hauptgehäuses (122) in Bezug zu einer Längsachse des Hauptteils (120) eine seitliche Außenseite ist und/oder wobei die Außenseite des Griffgehäuses (142) in Bezug zu einer Längsachse des Griffteils (140) eine seitliche Außenseite ist.
